# FASCICULE DE BREVET EUROPEEN

(11) **EP 3 974 855 B1**
(45) Date de publication et mention de la délivrance du brevet: **18.01.2023**
(21) Numéro de dépôt: 21181702.8
(22) Date de dépôt: 25.06.2021
(51) Int. Cl.: G01R 31/50, G01R 31/52, H02G 3/00, H02H 1/00, H02H 3/17, H02H 7/22

(54) **SYSTEME DE DETECTION DE DEFAUT DE CABLAGE ELECTRIQUE**
SYSTEM ZUR ERKENNUNG VON FEHLERN IN EINER ELEKTRISCHEN VERKABELUNG
SYSTEM FOR DETECTING AN ELECTRICAL WIRING FAULT

(30) Priorité: 29.09.2020 FR 2009873
(43) Date de publication de la demande: 30.03.2022
(73) Titulaire: AIRBUS OPERATIONS (S.A.S.), 31060 Toulouse (FR)
(72) Inventeur: OMS, Patrick, 31060 Toulouse (FR)
(74) Mandataire: Sarraméa, Claude

(56) Documents cités:
- EP-A1- 3 361 587
- EP-A1- 3 399 612
- EP-A1- 3 457 510
- EP-A1- 3 483 999
- EP-A1- 3 667 340
- WO-A1-2020/074128
- GB-A- 2 541 026
- US-A1- 2001 029 433
- US-A1- 2003 206 111
- US-A1- 2009 187 358

## Description

### DOMAINE TECHNIQUE

La présente invention concerne un système de détection de défaut de câblage électrique. La présente invention trouve notamment son application dans le domaine de l'aéronautique.

### ETAT DE LA TECHNIQUE ANTERIEURE

Une installation électrique comporte des câblages d'alimentation qui peuvent atteindre plusieurs dizaines de mètres. On entend par câblages les câbles d'alimentation ainsi que d'éventuelles connexions électriques entre ces câbles d'alimentation. Le long de ces câblages d'alimentation les conditions environnementales peuvent être différentes. Par exemple, dans un aéronef, un câblage électrique relie un générateur électrique en sortie de turboréacteur, typiquement au niveau d'une des ailes de l'aéronef, et un système à alimenter en énergie électrique, par exemple un centre de distribution d'énergie électrique dans la zone du cockpit de l'aéronef. Ce câblage électrique subit des variations de conditions environnementales, plus particulièrement de température, sur sa longueur. Ces variations peuvent être significatives au vu de la zone de câblage considérée (au niveau des ailes et selon si cette zone y est proche ou non du turboréacteur, au niveau de la cabine pressurisée, etc.), au vu de la phase opérationnelle dans laquelle se trouve l'aéronef (au sol, en vol) et au vu des conditions météorologiques (moment de la journée, saison, région du monde, etc.). On peut aussi noter une élévation de température du câblage électrique liée à l'effet Joule induit par le passage de courant dans le câblage électrique.

En cas d'usure d'un câble électrique ou de défaut de connexion électrique dans le câblage électrique, un arc série ou une élévation importante et locale de température au niveau d'une connexion peut se produire. La formation d'arc électrique est typiquement détectée grâce à des disjoncteurs, ce qui est particulièrement efficace vis-à-vis des arcs parallèles, mais ces disjoncteurs ne peuvent pas détecter la formation d'un arc série (car le courant n'augmente pas). Les variations de température le long des câblages électriques rendent une potentielle mesure de la chute de tension, entre le départ au générateur électrique et l'arrivée au centre de distribution d'énergie électrique, non significative, car la température influe sur la résistance des câbles électriques. Par exemple, la résistance du cuivre varie de 100% dans la plage de température de -40°C à +150°C, ce qui peut entraîner, pour une même intensité de courant, une différence de tension de 10 Volts, voire de 20 Volts, dans un câble d'alimentation électrique dans un aéronef. Une chute de tension liée à une formation d'un arc série ou une élévation de résistance d'une connexion étant du même ordre de grandeur, la détection du défaut dans le câblage électrique n'est donc pas possible par une simple mesure de la chute de tension du fait des variations de température évoquées. Bien que la dangerosité des arcs série est moindre que celle des arcs parallèles, il est souhaitable de pouvoir détecter de manière précoce des défauts de câblage électrique entraînant la formation d'arcs série ou d'augmentation de résistance de connexion, notamment dans une installation électrique d'aéronef, de manière à anticiper des opérations de maintenance.

Le document EP3399612A1 divulgue un système de détection pour détecter dans une installation électrique à tension continue un défaut dans un câblage électrique et comportant:
a) un autre câblage électrique destiné à être le long du câblage principal et de même longueur;
b) un générateur de courant contrôlable agencé pour injecter, en entrée de la gaine conductrice, un courant; et
c) une circuiterie électronique agencée pour mesurer la différence entre l'intensité du courant dans la gaine conductrice et un courant de référence, et pour détecter un défaut dans le câblage électrique principal lorsque ladite différence dépasse un seuil prédéfini.

### EXPOSE DE L'INVENTION

La présente invention concerne un système de détection tel que décrit dans la revendication 1.

A cet effet, il est proposé un système de détection pour détecter dans une installation électrique à tension continue un défaut dans un câblage électrique, dit câblage électrique principal, de section *S1*, le câblage électrique principal étant installé de sorte qu'il subit des variations de température ambiante sur sa longueur.

Selon un premier mode de réalisation non revendiqué, le système de détection comporte : un autre câblage électrique, dit câblage électrique témoin, destiné à être placé le long du câblage électrique principal, de même longueur que le câblage électrique principal, de même composition et de section S2 inférieure à la section *S1* ; un générateur de courant contrôlable injectant, en entrée du câble électrique témoin, un courant *I2* substantiellement égal à un courant *I1* parcourant le câblage électrique principal multiplié par un gain d'atténuation égal au rapport *S2*/*S1*, le câblage électrique principal et le câblage électrique témoin étant joints en sortie ; et une circuiterie électronique agencée pour comparer le potentiel électrique en entrée du câblage électrique principal et le potentiel électrique en entrée du câblage électrique témoin, et pour détecter un défaut dans le câblage électrique principal lorsque la différence desdits potentiels électriques dépasse un seuil prédéfini. Ainsi, un défaut du câblage électrique principal entraînant un arc série ou une élévation de température d'une connexion est détecté malgré les variations de température.

Selon un mode de réalisation particulier, le système de détection comporte une sonde de courant mesurant l'intensité du courant *I1*, et dans lequel la circuiterie électronique comporte : un atténuateur pilotant le générateur de courant contrôlable en fonction de l'intensité du courant *I1* mesurée par la sonde de courant ; un amplificateur différentiel faisant la différence entre le potentiel électrique en entrée du câblage électrique principal et le potentiel électrique en entrée du câblage électrique témoin ; et un comparateur comparant la sortie de l'amplificateur différentiel avec un potentiel prédéfini *Vref* correspondant audit seuil prédéfini.

Selon un mode de réalisation particulier, un filtre passe-bas est présent en sortie du comparateur.

Il est également proposé une installation électrique comportant un câblage électrique, dit câblage électrique principal, le câblage électrique principal étant destiné à être installé dans un environnement où le câblage électrique principal subit des variations de température ambiante sur sa longueur, et comportant en outre un système de détection tel que précédemment évoqué.

Selon un mode de réalisation particulier, le câblage électrique témoin est placé, sur sa longueur, contre le câblage électrique principal.

Selon un mode de réalisation particulier, l'installation électrique comporte en outre un disjoncteur et dans laquelle la circuiterie électronique est agencée pour déclencher le disjoncteur lorsque le potentiel électrique en entrée du câblage électrique principal et le potentiel électrique en entrée du câblage électrique témoin dépasse le seuil prédéfini.

Il est également proposé un aéronef comportant une installation électrique telle qu'évoquée ci-dessus, le câblage électrique principal étant installé dans des zones de l'aéronef soumises à des températures ambiantes différentes.

Selon un mode de réalisation particulier, le câblage électrique principal est installé entre un générateur électrique installé au niveau d'une aile de l'aéronef en sortie d'un turboréacteur et un centre de distribution électrique installé dans la cabine pressurisée de l'aéronef.

Selon un deuxième mode de réalisation, non-revendiqué, le système de détection comporte : un autre câblage électrique, dit câblage électrique témoin, de section S2 inférieure à la section *S1*, destiné à être placé en aller et retour le long du câblage électrique principal ; un dispositif de surveillance ; un câble de retour ramenant le potentiel électrique en sortie du câblage électrique principal vers le dispositif de surveillance. De plus, le dispositif de surveillance comporte : un générateur de courant contrôlable injectant, en entrée du câble électrique témoin, un courant *I2* égal à un courant *I1* atténué par un facteur d'atténuation *G1*, le courant *I1* parcourant le câblage électrique principal, le générateur de courant contrôlable étant connecté entre l'entrée et la sortie du câblage électrique témoin, le facteur d'atténuation *G1* étant tel que les courants *I1* et *I2* entraînent respectivement la même élévation de température dans le câblage électrique principal et dans le câblage électrique témoin ; et une circuiterie électronique comportant un premier amplificateur différentiel réalisé grâce à un amplificateur opérationnel connecté sur une première entrée à l'entrée du câblage électrique principal et sur une seconde entrée à la sortie du câblage électrique principal, via le câble de retour, la circuiterie électronique étant agencée pour déterminer une différence de tensions entre la sortie du premier amplificateur différentiel et une adaptation grâce à un gain G2 de la tension entre l'entrée et la sortie du câblage électrique témoin, avec G2 = *S2* / (*2.G1.S1*)*,* et pour détecter un défaut dans le câblage électrique principal lorsque ladite différence de tensions dépasse une marge prédéfinie. Ainsi, un défaut du câblage électrique principal entraînant un arc série ou une élévation de température d'une connexion est détecté malgré les variations de température.

Selon un mode de réalisation particulier, le système de détection comporte une sonde de courant mesurant l'intensité du courant *I1*, et dans lequel la circuiterie électronique comporte : un atténuateur pilotant le générateur de courant contrôlable en fonction de l'intensité du courant *I1* mesurée par la sonde de courant ; un second amplificateur différentiel agencé pour indiquer en sortie une valeur, adaptée grâce au gain G2, de tension entre l'entrée et la sortie du câblage électrique témoin ; un troisième amplificateur différentiel agencé pour indiquer en sortie quelle différence existe entre la tension en sortie du second amplificateur différentiel et la tension en sortie du premier amplificateur différentiel ; et un comparateur comparant la sortie du troisième amplificateur différentiel avec un potentiel prédéfini *Vref* correspondant à ladite marge prédéfinie.

Selon un mode de réalisation particulier, un filtre passe-bas est présent en sortie du comparateur.

Il est également proposé une installation électrique comportant un câblage électrique, dit câblage électrique principal, le câblage électrique principal étant destiné à être installé dans un environnement où le câblage électrique principal subit des variations de température ambiante sur sa longueur, et comportant en outre un système de détection tel qu'évoqué ci-dessus.

Selon un mode de réalisation particulier, le câblage électrique témoin est placé, sur sa longueur d'aller et retour, contre le câblage électrique principal.

Selon un mode de réalisation particulier, l'installation électrique comporte en outre un disjoncteur et dans laquelle la circuiterie électronique est agencée pour déclencher le disjoncteur lorsque la différence de tensions entre la sortie du premier amplificateur différentiel et l'adaptation grâce à un gain *G2* de la tension entre l'entrée et la sortie du câblage électrique témoin dépasse ladite marge prédéfinie.

Il est également proposé un aéronef comportant une installation électrique telle qu'évoquée ci-dessus, le câblage électrique principal étant installé dans des zones de l'aéronef soumises à des températures ambiantes différentes.

Selon un mode de réalisation particulier, le câblage électrique principal est installé entre un générateur électrique installé au niveau d'une aile de l'aéronef en sortie d'un turboréacteur et un centre de distribution électrique installé dans la cabine pressurisée de l'aéronef.

### BREVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
La Figure 1 illustre schématiquement, en vue de dessus, un aéronef équipé d'une installation électrique comportant un système de détection de défaut de câblage électrique selon un premier mode de réalisation de l'invention ;
La Figure 2 illustre schématiquement une section en coupe simplifiée d'un agencement particulier des câblages électriques dans l'installation électrique selon un premier mode de réalisation de l'invention ;
La Figure 3 illustre schématiquement un agencement du système de détection de défaut de câblage électrique dans l'installation électrique selon un premier mode de réalisation de l'invention ;
La Figure 4 illustre des évolutions de potentiels électriques, au fil du temps, dans l'installation électrique selon un premier mode de réalisation de l'invention ;
La Figure 5 illustre schématiquement, en vue de dessus, un aéronef équipé d'une installation électrique comportant un système de détection de défaut de câblage électrique selon un deuxième mode de réalisation de l'invention ;
La Figure 6 illustre schématiquement une section en coupe simplifiée d'un agencement particulier des câblages électriques dans l'installation électrique selon un deuxième mode de réalisation de l'invention ;
La Figure 7 illustre schématiquement un agencement du système de détection de défaut de câblage électrique dans l'installation électrique selon un deuxième mode de réalisation de l'invention ; et
La Figure 8 illustre des évolutions de potentiels électriques, au fil du temps, dans l'installation électrique selon un deuxième mode de réalisation de l'invention.

### EXPOSE DETAILLE DE MODES DE REALISATION

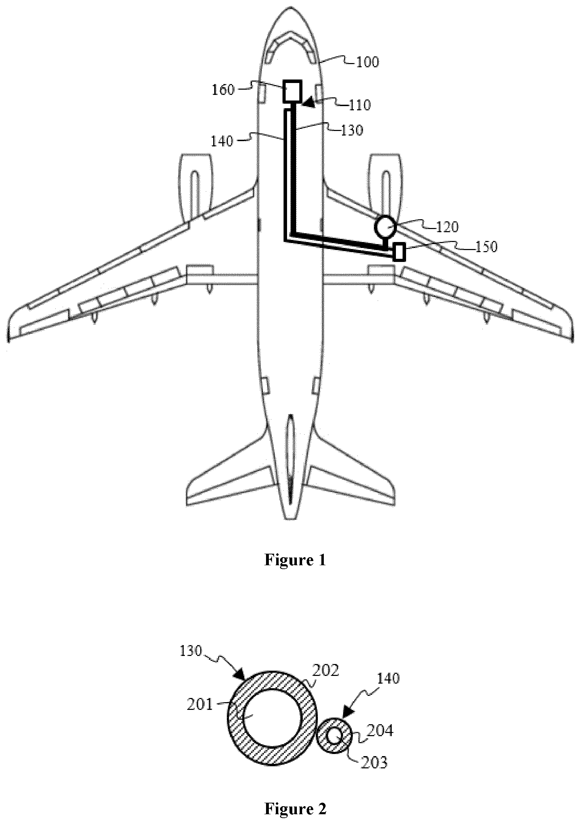

La Figure 1 illustre schématiquement, en vue de dessus, un aéronef 100 équipé d'une installation électrique 110 comportant un système de détection de défaut de câblage électrique dans l'installation électrique 110 selon un premier mode de réalisation de l'invention.

L'installation électrique comporte une source électrique 120 et un système électrique 160 (on parle typiquement de *charge*) à alimenter électriquement grâce à la source électrique 120. La source électrique 120 et le système électrique 160 sont reliés grâce à un câblage électrique 130. Le câblage électrique 130 comporte au moins un câble d'alimentation électrique, et éventuellement en outre une ou plusieurs connexions électriques. L'installation électrique 110 est sujette à des variations de température le long du câblage électrique 130. Il est par exemple considéré que la source électrique 120 est un générateur électrique en sortie (prélèvement mécanique) d'un turboréacteur de l'aéronef 100 et que le système électrique 160 est un centre de distribution électrique de l'aéronef 100. Il est en outre considéré dans cet exemple que le câblage électrique 130 court dans une des ailes de l'aéronef 100, puis dans la cabine pressurisée de l'aéronef 100. Le câblage électrique 130 traverse ainsi trois zones Z1, Z2, Z3 ayant des conditions environnementales différentes, plus particulièrement en termes de température ambiante. La zone Z1 correspond à une zone de l'aile qui couvre une distance D autour du turboréacteur, la zone Z2 correspond à une zone de l'aile au-delà de la distance D, et la zone Z3 correspond à la cabine pressurisée de l'aéronef 100.

Le système de détection de défaut de câblage électrique comporte un câblage électrique 140 qui court le long du câblage électrique 130, de même longueur que ce dernier. Le câblage électrique 140 sert de câblage électrique de référence, et est installé de sorte à subir les mêmes variations environnementales, notamment en termes de température, que le câblage électrique 130. Dans les présentes, le câblage électrique 130 est dénommé *câble électrique principal* et le câblage électrique 140 est dénommé *câblage électrique témoin.*

Le câblage électrique témoin 140 est de même composition que le câblage électrique principal 130. Notamment, les câbles électriques ont des âmes conductrices de même alliage. Le câblage électrique témoin 140 présente toutefois une section S2 inférieure à la section *S1* du câblage électrique principal 130, permettant ainsi de limiter le poids induit par le câblage électrique témoin 140. La résistance *R2* du câblage électrique témoin 140 est donc supérieure à la résistance *R1* du câblage électrique principal 130.

Une installation particulière du câblage électrique témoin 140 vis-à-vis du câblage électrique principal 130 est présentée sur la Figure 2. Y sont montrées en coupe simplifiée une âme conductrice 201 (typiquement en cuivre) entourée d'une gaine isolante 202 du câblage électrique principal 130, et une âme conductrice 203 (typiquement en cuivre) entourée d'une gaine isolante 204 du câblage électrique témoin 140. Sur la Figure 2, le câblage électrique témoin 140 est placé, sur sa longueur, contre le câblage électrique principal 130, de sorte à homogénéiser leur élévation de température relative à l'effet Joule. Pour ce faire, le câblage électrique témoin 140 peut être attaché ou collé au câblage électrique principal 130.

Le câblage électrique témoin 140 est connecté au câblage électrique principal 130 en sortie du câblage électrique principal 130, c'est-à-dire au niveau de la charge 160. Le câblage électrique témoin 140 et le câblage électrique principal 130 présentent donc le même potentiel électrique en leur point de jonction.

Le système de détection de défaut de câblage électrique comporte en outre un dispositif de surveillance 150 agencé pour injecter dans le câblage électrique témoin 140 un courant *I2* proportionnel au courant *I1* injecté par la source électrique 120 en entrée du câblage électrique principal 130. Le courant *I2* est substantiellement égal au courant *I1* parcourant le câblage électrique principal 130 multiplié par un gain d'atténuation égal au rapport *S2*/*S1.* Le dispositif de surveillance 150 est en outre agencé pour mesurer la différence entre le potentiel électrique en entrée du câblage électrique principal 130 (c'est-à-dire au niveau de la source électrique 120) et le potentiel électrique en entrée du câblage électrique témoin 140, et pour détecter un défaut dans le câblage électrique principal 130 lorsque la différence desdits potentiels électriques dépasse un seuil prédéfini.

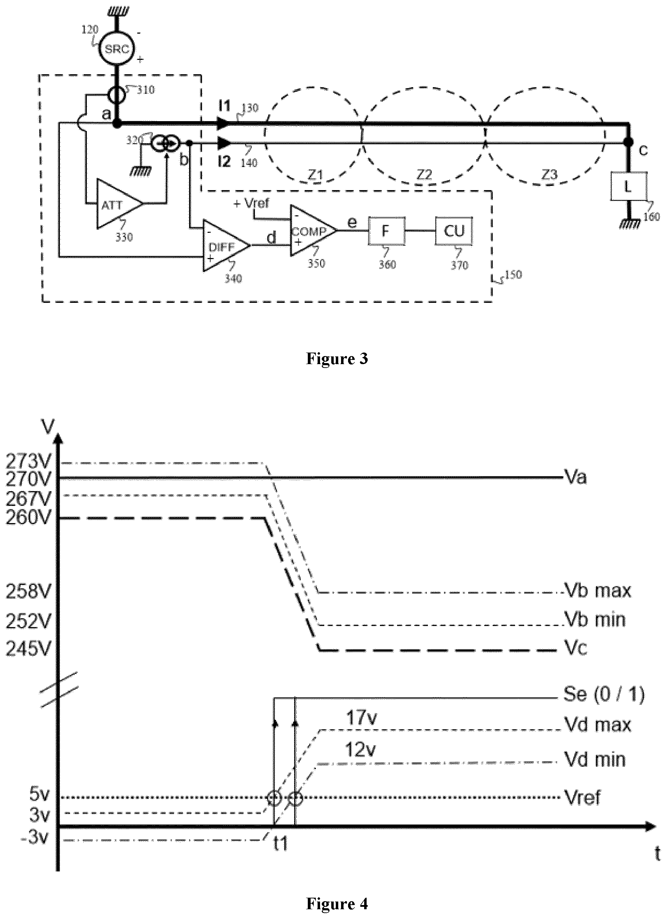

La Figure 3 illustre schématiquement un mode de réalisation particulier du système de détection de défaut de câblage électrique, et plus particulièrement du dispositif de surveillance 150. La Figure 3 montre la charge L 160 connectée à la source électrique SRC 120 grâce au câblage électrique principal 130. Un courant *I1* circule dans le câblage électrique principal 130. La Figure 3 montre aussi le câblage électrique témoin 140 installé le long du câblage électrique principal 130, et joint au câblage électrique principal 130 en un point c juste en amont de la charge L 160. Ainsi, la dissipation thermique due à l'effet Joule est similaire dans les deux câblages électriques, et donc la variation de résistance l'est également, de même que les chutes de tension induites. La différence entre les chutes de tension apparaissant sur les deux câblages électriques reste donc proche de 0 Volts (à une marge prédéfinie près) tant qu'il n'y a pas de défaut dans le câblage électrique principal 130. Le dispositif de surveillance 150 comporte une sonde de courant 310 installée juste en amont de l'entrée du câblage électrique principal 130, afin de mesurer l'intensité du courant *I1*. Le dispositif de surveillance 150 comporte en outre un atténuateur ATT 330 en charge de piloter un générateur de courant contrôlable 320 en entrée du câblage électrique témoin 140, en fonction de l'intensité du courant *I1* mesurée par la sonde de courant 310. L'atténuateur ATT 330 a un gain *G1* = *R1*/*R2* = *S2*/*S1.* Ainsi un courant *I2* = *G1.I1* dans le câblage électrique témoin 140. Ainsi, en l'absence de défaut sur le câblage électrique principal 130, la tension *Uac* entre l'entrée *a* du câblage électrique principal 130 et le point de jonction susmentionné c et la tension *Ubc* entre l'entrée *b* du câblage électrique témoin 140 et le point de jonction susmentionné c sont égales, à une marge d'erreur prédéfinie potentielle (seuil prédéfini) près. Le dispositif de surveillance 150 comporte en outre un amplificateur différentiel DIFF 340, connecté sur une première entrée à l'entrée *b* du câblage électrique témoin 140 et sur une seconde entrée à l'entrée *a* du câblage électrique principal 130. L'amplificateur différentiel DIFF 340 est agencé pour mesurer la différence entre le potentiel électrique en entrée du câblage électrique principal 130 et le potentiel électrique en entrée du câblage électrique témoin 140. La différence entre ces deux potentiels électriques est fournie en sortie *d* de l'amplificateur différentiel DIFF 340. Par exemple, l'amplificateur différentiel DIFF 340 est un amplificateur opérationnel de gain G2=1, en montage soustracteur, où la première entrée est l'entrée « - » et la seconde entrée est l'entrée « + ». Le branchement inverse des entrées est aussi possible à condition d'inverser aussi la polarité de la tension Vref, ou d'inverser les entrées du comparateur COMP 350 (détaillé ci-après).

Le dispositif de surveillance 150 comporte en outre un comparateur COMP 350, sur une première entrée « - » duquel étant appliqué un potentiel prédéfini *Vref* correspondant à la marge d'erreur prédéfinie potentielle susmentionnée, et sur une seconde entrée « + » duquel étant connectée la sortie *d* de l'amplificateur différentiel DIFF 340. Un état bas en sortie e du comparateur COMP 350 indique un fonctionnement normal du câblage électrique principal 130 et un état haut en sortie *e* du comparateur COMP 350 indique un fonctionnement anormal du câblage électrique principal 130, à savoir un défaut du câblage électrique principal 130 ayant entraîné la formation d'un arc série ou une augmentation anormale de la résistance de connexion.

Le dispositif de surveillance 150 comporte en outre une unité de contrôle CU 370 agencée pour surveiller l'état, haut ou bas, en sortie e du comparateur COMP 350, et d'actionner un mécanisme de réaction à la détection de défaut du câblage électrique principal 130. Préférentiellement, l'unité de contrôle CU 370 est un déclencheur d'un disjoncteur qui est placé en amont du câblage électrique principal 130 de manière à cesser l'alimentation électrique via le câblage électrique principal 130. Une alimentation électrique de secours prend alors le relai pour alimenter électriquement la charge L 160 au besoin. En variante ou en complément, l'unité de contrôle CU 370 inclut une interface de communication adaptée pour signaler la détection de défaut du câblage électrique principal 130, par exemple à un instrument de bord dans le cockpit ou à un serveur de maintenance embarqué.

Le dispositif de surveillance 150 peut en outre comporter un filtre passe-bas F 360 en sortie *e* du comparateur COMP 350 (en amont de l'unité de contrôle CU 370) afin d'effectuer un filtrage d'éventuelles interférences électromagnétiques et de laisser le temps à la température des câblages électriques de se stabiliser lors de variations de courant, évitant ainsi des détections intempestives.

D'autres agencements du dispositif de surveillance 150 sont possibles à partir d'une circuiterie électronique, dès lors que le courant approprié *I2* est injecté dans le câblage électrique témoin 140 et que les fonctions de comparaison et de mesure de différence détaillées ci-dessus sont réalisées. Par exemple, les fonctions réalisées par l'atténuateur ATT 330 et/ou l'amplificateur différentiel DIFF 340 et/ou le comparateur COMP 350 et/ou l'unité de contrôle CU 370 peuvent être réalisées grâce à un FPGA (« Field-Programmable Gate Array » en anglais) ou un ASIC (« Application-Specific Integrated Circuit » en anglais), un DSP (« Digital Signal Processor » en anglais) ou un ensemble formé d'un microcontrôleur et d'une mémoire stockant un programme d'ordinateur comportant des instructions causant l'implémentation par le microcontrôleur des fonctions en question.

La Figure 4 illustre des évolutions de potentiels électriques, au fil du temps, dans l'installation électrique 110. De manière illustrative, il est considéré que les âmes des câblages électriques sont en cuivre, de longueur 100 mètres, que la section S1 est de 50 mm² et que cela représente une résistance à +60°C de 40 mΩ et une tension *Uac* de 10 V pour un courant *I1* de 250 A. De plus, il est considéré que la section S2 est de 0.75 mm² et que cela représente une résistance à +60°C de 2.67 Ω et une tension *Ubc* de 10 V pour un courant *I2* de 3.75 A. Considérant que la différence normale entre *Uac* et *Ubc* est de ± 3 V (c'est-à-dire que le potentiel électrique *Vb* de l'entrée *b* du câblage électrique témoin 140 est compris entre une valeur minimum *Vb min* et une valeur maximum *Vb max* écartées de 3 V par rapport au potentiel électrique *Va* de l'entrée *a* du câblage électrique principal 130), la valeur de +*Vref* est fixée à 5 V. Il est enfin considéré que la survenue d'un défaut du câblage électrique principal 130 entraîne une chute de tension de 15 V dans le cadre d'une alimentation électrique de 270 V continu (DC).

A l'instant *t1*, un défaut du câblage électrique principal 130 apparaît, entraînant une formation d'arc série ou une forte élévation de température dans une connexion. Le potentiel électrique *Vc* au point de jonction *c* décroît, ainsi que le potentiel électrique *Vb.* La formation d'arc série maintient le potentiel *Va.* En conséquence, le potentiel *Vd* (compris entre une valeur minimum *Vd min* et une valeur maximum *Vd max* écartées entre-elles de 6 V) en sortie *d* de l'amplificateur différentiel DIFF 340 croît. En franchissant le seuil défini par *Vref*, l'état *Se* de la sortie *e* du comparateur COMP 350 passe de l'état bas (« 0 ») à l'état haut (« 1 »), ce qui représente la détection du défaut du câblage électrique principal 130.

Si la tension électrique *Uac* devait varier à cause de variations de température le long du câblage électrique principal, la tension *Ubc* varierait de la même manière étant donné que le câblage électrique témoin 140 est installé le long du câblage électrique principal 130 et que le courant *I2* est ajusté sur le courant *I1*. Un défaut du câblage électrique principal 130 entraînant la formation d'un arc série ou d'une élévation de résistance de connexion, et donc de température de cette connexion, serait détecté malgré ces variations de température. L'exposé ci-dessus détaille des modes de réalisation reposant sur un générateur électrique fournissant une tension continue positive. Les adapter à un générateur fournissant une tension continue négative est alors trivial pour l'homme du métier (sens du courant, branchement des entrées de l'amplificateur différentiel DIFF 340 et du comparateur COMP 350, etc.).

Dans le cas d'un générateur de tension alternative, les tensions « a » en sortie de la source électrique SRC 120 et « b » en sortie du générateur de courant contrôlable 320 sont en amont transformées en valeur efficace (dite valeur RMS, « Root Mean Square » en anglais), en utilisant par exemple un convertisseur ou un redresseur double alternance sans seuil suivi d'un filtre passe-bas, avant d'entrer sur l'amplificateur différentiel DIFF 340.

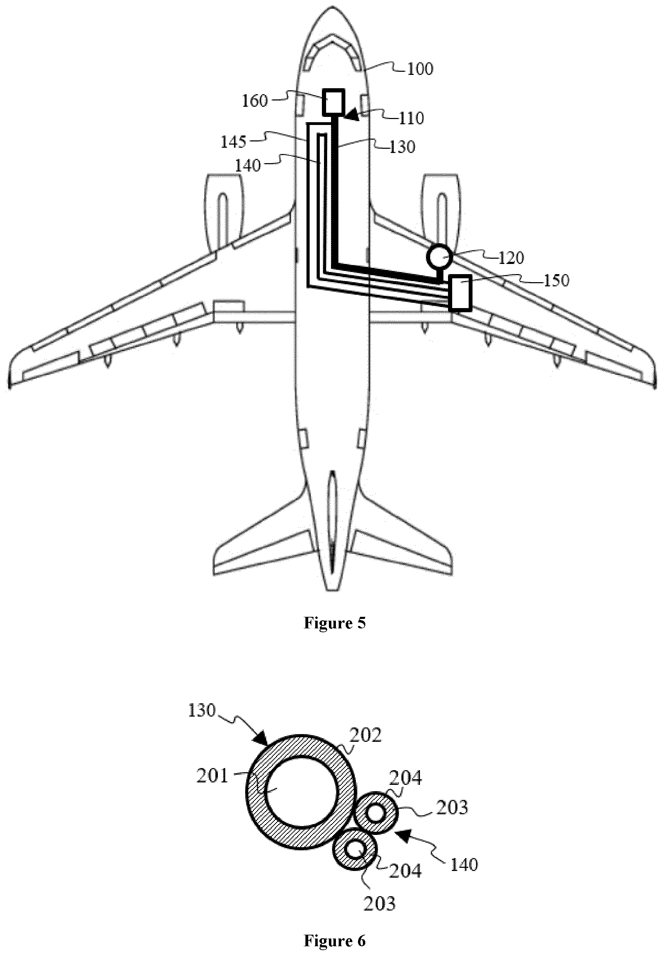

La Figure 5 illustre schématiquement, en vue de dessus, un aéronef 100 équipé d'une installation électrique 110 comportant un système de détection de défaut de câblage électrique dans l'installation électrique 110 selon un deuxième mode de réalisation de l'invention.

L'installation électrique comporte une source électrique 120 et un système électrique 160 (on parle typiquement de *charge*) à alimenter électriquement grâce à la source électrique 120. La source électrique 120 et le système électrique 160 sont reliés grâce à un câblage électrique 130. Le câblage électrique 130 comporte au moins un câble d'alimentation électrique, et éventuellement en outre une ou plusieurs connexions électriques. L'installation électrique 110 est sujette à des variations de température le long du câblage électrique 130. Il est par exemple considéré que la source électrique 120 est un générateur électrique en sortie (prélèvement mécanique) d'un turboréacteur de l'aéronef 100 et que le système électrique 160 est un centre de distribution électrique de l'aéronef 100. Il est en outre considéré dans cet exemple que le câblage électrique 130 court dans une des ailes de l'aéronef 100, puis dans la cabine pressurisée de l'aéronef 100. Le câblage électrique 130 traverse ainsi trois zones Z1, Z2, Z3 ayant des conditions environnementales différentes, plus particulièrement en termes de température ambiante. La zone Z1 correspond à une zone de l'aile qui couvre une distance D autour du turboréacteur, la zone Z2 correspond à une zone de l'aile au-delà de la distance D, et la zone Z3 correspond à la cabine pressurisée de l'aéronef 100.

Le système de détection de défaut de câblage électrique comporte un câblage électrique 140, qui court en aller et retour le long du câblage électrique 130, entre l'entrée du câblage électrique 130 et la sortie du câblage électrique 130, c'est-à-dire sur la portion de câble électrique à surveiller. Le câblage électrique 140 a ainsi une forme de boucle longiligne. L'installation du câblage électrique 140 est alors telle que la portion du câblage électrique 140 qui relie l'aller et le retour le long dudit câblage électrique 130 est de longueur négligeable par rapport à la longueur dudit câblage électrique 130.

Le câblage électrique 140 sert de câblage électrique de référence, et est ainsi installé l'aller (comme le retour) de sorte à subir les mêmes variations environnementales, notamment en termes de température, que le câblage électrique 130. Dans les présentes, le câblage électrique 130 est dénommé *câble électrique principal* et le câblage électrique 140 est dénommé *câblage électrique témoin.*

Le câblage électrique témoin 140 présente toutefois une section S2 inférieure à la section *S1* du câblage électrique principal 130, permettant ainsi de limiter le poids induit par le câblage électrique témoin 140. La résistance R2 du câblage électrique témoin 140 est donc supérieure à la résistance R1 du câblage électrique principal 130. Cela permet que le courant circulant dans le câblage électrique témoin 140 soit nettement inférieur au courant circulant dans le câblage électrique principal 130.

Une installation particulière du câblage électrique témoin 140 vis-à-vis du câblage électrique principal 130 est présentée sur la Figure 6. Y sont montrées en coupe simplifiée une âme conductrice 201 (typiquement en cuivre) entourée d'une gaine isolante 202 du câblage électrique principal 130, et une âme conductrice 203 (typiquement en cuivre) entourée d'une gaine isolante 204 du câblage électrique témoin 140. Sur la Figure 6, le câblage électrique témoin 140 est placé, sur l'aller et sur le retour, contre le câblage électrique principal 130, de sorte à homogénéiser leur élévation de température relative à l'effet Joule. Pour ce faire, le câblage électrique témoin 140 peut être attaché ou collé au câblage électrique principal 130.

Le système de détection de défaut de câblage électrique comporte en outre un dispositif de surveillance 150 comportant un générateur de courant contrôlable agencé pour injecter en entrée du câblage électrique témoin 140 un courant *I2* égal au courant *I1* atténué par un facteur d'atténuation *G1*, le courant *I1* étant injecté par la source électrique 120 en entrée du câblage électrique principal 130, le générateur de courant contrôlable étant connecté entre l'entrée et la sortie du câblage électrique témoin 140.

Le système de détection de défaut de câblage électrique comporte en outre un câble de retour 145. Le câble de retour 145 ramène le potentiel électrique en sortie du câblage électrique principal 130 vers le dispositif de surveillance 150, c'est-à-dire là où sont localisées l'entrée et la sortie du câblage électrique témoin 140. Comme expliqué ci-après, le câble de retour 145 est connecté en entrée d'un amplificateur différentiel réalisé grâce à un amplificateur opérationnel. Un faible courant, par exemple de l'ordre de quelques microampères, circule dans le câble de retour 145. Donc, même si les conditions de température font varier la résistance du câble de retour, la différence potentielle entre les deux extrémités du câble de retour 145 est négligeable. Par exemple, si le courant dans le câble de retour 145 est de 1 µA et que la résistance du câble de retour 145 est de l'ordre de 10 Ω, l'imprécision de mesure est de 10 µV, ce qui est effectivement négligeable.

Le dispositif de surveillance 150 est en outre agencé pour déterminer une différence de tensions entre, d'un côté, la tension entre l'entrée et la sortie du câblage électrique principal 130, et d'un autre côté, une adaptation grâce à un gain *G2* de la tension entre l'entrée et la sortie du câblage électrique témoin 140, avec *G2* = *S2* / *(2.G1.S1)*, et pour détecter un défaut dans le câblage électrique principal 130 lorsque cette différence de tensions s'écarte au-delà d'une marge prédéfinie.

Le facteur d'atténuation *G1* est tel que les courants *I1* et *I2* entraînent respectivement la même élévation de température dans le câblage électrique principal 130 et dans le câblage électrique témoin 140. Ainsi, en l'absence de défaut sur le câblage électrique principal 130, la différence de tensions susmentionnée est contenue dans la marge prédéfinie.

Le rapport entre la section *S1* et la section *S2* peut ainsi être défini en fonction d'un courant *I2* cible dans le câblage électrique témoin 140 au vu d'un courant *I1* attendu dans le câblage électrique principal 130. Le rapport entre la section *S1* et la section *S2* tient également compte préférentiellement de la résistance thermique des gaines isolantes 202 et 204, si elles diffèrent. D'autres paramètres peuvent intervenir, comme l'alliage utilisé pour les âmes conductrices 201, 203, l'agencement des âmes conductrices (tressage ou non), la gamme de tensions d'utilisation, etc.

Dans un mode de réalisation, le câblage électrique témoin 140 est de même composition que le câblage électrique principal 130. Notamment, les câbles électriques ont des âmes conductrices de même alliage. Il est alors par exemple possible de choisir une section *S1* de 50 mm² pour une valeur nominale du courant *I1* de 200 A, et une section *S2* de 0.75 mm² pour une valeur nominale du courant *I2* de 15 A.

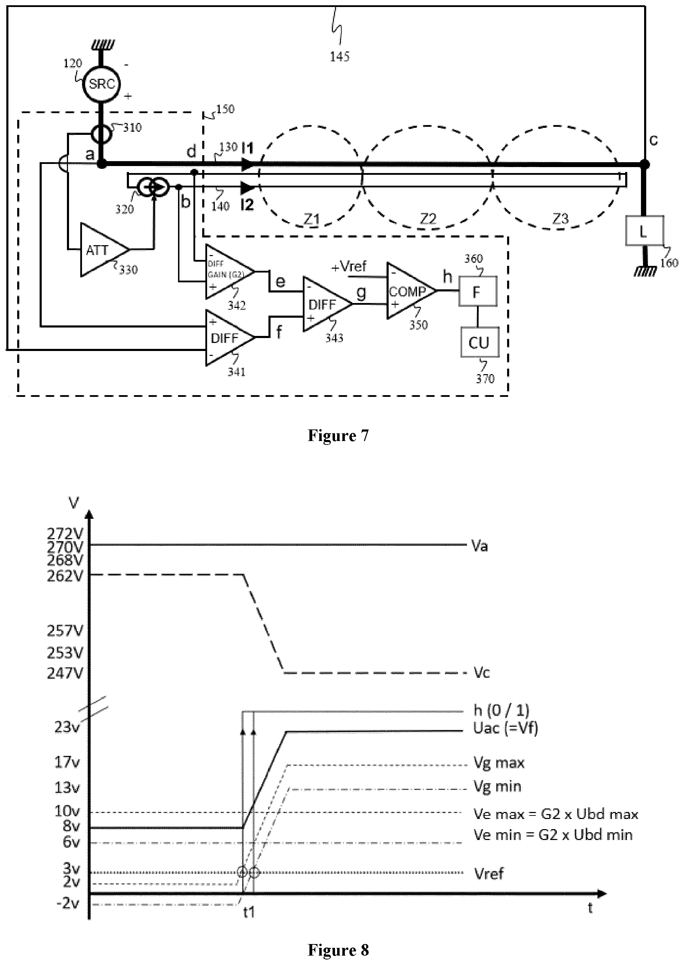

La Figure 7 illustre schématiquement un mode de réalisation particulier du système de détection de défaut de câblage électrique, et plus particulièrement du dispositif de surveillance 150. La Figure 7 montre la charge L 160 connectée à la source électrique SRC 120 grâce au câblage électrique principal 130. Un courant *I1* circule dans le câblage électrique principal 130. La Figure 7 montre aussi le câblage électrique témoin 140 installé, par un aller et un retour, le long du câblage électrique principal 130. Ainsi, la dissipation thermique due à l'effet Joule est similaire dans les deux câblages électriques, et donc la variation de résistance l'est également, de même que les chutes de tension induites tant qu'il n'y a pas de défaut dans le câblage électrique principal 130.

Le dispositif de surveillance 150 comporte une sonde de courant 310 installée juste en amont de l'entrée *a* du câblage électrique principal 130, afin de mesurer l'intensité du courant *I1*. Le dispositif de surveillance 150 comporte en outre un atténuateur ATT 330 en charge de piloter un générateur de courant contrôlable 320 injectant un courant *I2* dans le câblage électrique témoin 140. Comme le montre la Figure 7, le générateur de courant contrôlable 320 est connecté entre l'entrée *b* et la sortie *d* du câblage électrique témoin 140. L'intensité du courant *I2* est définie en fonction de l'intensité du courant *I1* mesurée par la sonde de courant 310. L'atténuateur ATT 330 a un gain *G1* comme défini ci-dessus. Ainsi le courant *I2* est tel que *I2* = *G1.I1* dans le câblage électrique témoin 140.

Le dispositif de surveillance 150 comporte en outre un premier amplificateur différentiel DIFF 341, connecté sur une première entrée à l'entrée *a* du câblage électrique principal 130 et sur une seconde entrée à la sortie *c* du câblage électrique principal 130, via le câble de retour 145. Le amplificateur différentiel DIFF 341 est agencé pour indiquer en sortie *f* quelle valeur de tension *Uac* existe entre l'entrée *a* du câblage électrique principal 130 et la sortie c du câblage électrique principal 130. Autrement dit, le premier amplificateur DIFF 341 est agencé pour indiquer en sortie une valeur de tension égale à la chute de tension aux bornes du câblage électrique principal 130. Le premier amplificateur différentiel DIFF 341 est réalisé grâce à un amplificateur opérationnel de gain G3 = 1, où la première entrée est l'entrée « + » et la seconde entrée est l'entrée « - ». Le branchement inverse des entrées est aussi possible.

Le dispositif de surveillance 150 comporte en outre un second amplificateur différentiel DIFF 342, connecté sur une première entrée à l'entrée *b* du câblage électrique témoin 140 et sur une seconde entrée à la sortie *d* du câblage électrique témoin 140. Ainsi, le second amplificateur différentiel DIFF 342 est agencé pour indiquer en sortie *e* une valeur, adaptée grâce au gain *G2,* de tension *Ubd* entre l'entrée *b* du câblage électrique témoin 140 et la sortie *d* du câblage électrique témoin 140. Par exemple, le second amplificateur différentiel DIFF 342 est réalisé grâce à un amplificateur opérationnel de gain *G2* = *S2* / *(2.G1.S1)*, où la première entrée est l'entrée « - » et la seconde entrée est l'entrée « + ». Le branchement inverse des entrées est aussi possible.

Le dispositif de surveillance 150 comporte en outre un troisième amplificateur différentiel DIFF 343, connecté sur une première entrée à la sortie e du second amplificateur différentiel DIFF 342 et sur une seconde entrée à la sortie *f* du premier amplificateur différentiel DIFF 341. Le troisième amplificateur différentiel DIFF 343 est agencé pour indiquer en sortie *g* quelle différence existe entre la tension *Uac* et la tension *Ubd* adaptée par le gain G2. Le troisième amplificateur différentiel DIFF 343 est par exemple réalisé grâce à un amplificateur opérationnel de gain *G4* = 1, où la première entrée est l'entrée « - » et la seconde entrée est l'entrée « + ». Le branchement inverse des entrées est aussi possible. Le dispositif de surveillance 150 comporte en outre un comparateur COMP 350, sur une première entrée « + » duquel étant appliqué un potentiel prédéfini +*Vref* correspondant à la marge prédéfinie susmentionnée, et sur une seconde entrée « - » duquel étant connectée la sortie g du troisième amplificateur différentiel DIFF 343. Un état bas en sortie *h* du comparateur COMP 350 indique un fonctionnement normal du câblage électrique principal 130 et un état haut en sortie *h* du comparateur COMP 350 indique un fonctionnement anormal du câblage électrique principal 130, à savoir un défaut du câblage électrique principal 130 ayant entraîné la formation d'un arc série ou une élévation de température d'une connexion.

Le dispositif de surveillance 150 comporte en outre une unité de contrôle CU 370 agencée pour surveiller l'état, haut ou bas, en sortie g du comparateur COMP 350, et d'actionner un mécanisme de réaction à la détection de défaut du câblage électrique principal 130. Préférentiellement, l'unité de contrôle CU 370 est un déclencheur d'un disjoncteur qui est placé en amont du câblage électrique principal 130 de manière à cesser l'alimentation électrique via le câblage électrique principal 130. Une alimentation électrique de secours prend alors le relai pour alimenter électriquement la charge L 160 au besoin. En variante ou en complément, l'unité de contrôle CU 370 inclut une interface de communication adaptée pour signaler la détection de défaut du câblage électrique principal 130, par exemple à un instrument de bord dans le cockpit ou à un serveur de maintenance embarqué.

Le dispositif de surveillance 150 peut en outre comporter un filtre passe-bas F 360 en sortie g du comparateur COMP 350 (en amont de l'unité de contrôle CU 370) afin d'effectuer un filtrage d'éventuelles interférences électromagnétiques et de laisser le temps à la température des câblages électriques de se stabiliser lors de variations de courant, évitant ainsi des détections intempestives.

D'autres agencements du dispositif de surveillance 150 sont possibles à partir d'une circuiterie électronique. Par exemple, les fonctions réalisées par l'atténuateur ATT 330 et/ou le premier amplificateur différentiel DIFF 341 et/ou le second amplificateur différentiel DIFF 342 et/ou le troisième amplificateur différentiel DIFF 343 et/ou le comparateur COMP 350 et/ou l'unité de contrôle CU 370 peuvent être réalisées grâce à un FPGA (« Field-Programmable Gate Array » en anglais) ou un ASIC (« Application-Specific Integrated Circuit » en anglais), un DSP (« Digital Signal Processor » en anglais) ou un ensemble formé d'un microcontrôleur et d'une mémoire stockant un programme d'ordinateur comportant des instructions causant l'implémentation par le microcontrôleur des fonctions en question.

La Figure 8 illustre des évolutions de potentiels électriques, au fil du temps, dans l'installation électrique 110. De manière illustrative, il est considéré que les âmes des câblages électriques sont en cuivre. Il est en outre considéré que la longueur du câblage électrique principal 130 est de 100 mètres, de section *S1* de 50 mm², et que cela représente une résistance à +60°C de 40 mΩ. En considérant un courant *I1* nominal de 200 A, cela entraîne une tension *Uac* nominale de 8 V. De plus, il est considéré que la longueur du câblage électrique témoin 140 est de 200 mètres, de section S2 de 0.75 mm², et que cela représente une résistance à +60°C de 5.33 Ω. Alors, la tension *Ubd* nominale est de 80 V, *G1* = 0.075 et G2 = 0.1. Considérant que la différence normale entre *Uac* et *G2. Ubd* (c'est-à-dire la valeur en sortie e du second amplificateur différentiel DIFF 342) est de ± 2 V, la valeur de *Vref* est fixée à 3 V. Il est enfin considéré que la survenue d'un défaut du câblage électrique principal 130 entraîne une chute de tension de 15 V dans le cadre d'une alimentation électrique de 270 V continu (DC).

A l'instant *t1*, un défaut du câblage électrique principal 130 apparaît, entraînant une formation d'arc série ou une forte élévation de température dans une connexion. Le potentiel électrique *Vc* en sortie c du câblage électrique principal 130 décroît, ainsi que le potentiel électrique *Vb* en entrée *b* du câblage électrique témoin 140. La formation d'arc série maintient le potentiel électrique *Va* en entrée du câblage électrique principal 130. En conséquence, la tension *Uac* augmente, ce qui augmente la tension en sortie *g* du troisième amplificateur différentiel DIFF 343. Lorsque la tension en sortie g du troisième amplificateur différentiel DIFF 343 franchit *Vref*, l'état *Sh* de la sortie *h* du comparateur COMP 350 passe de l'état bas (« 0 ») à l'état haut (« 1 »), ce qui représente la détection du défaut du câblage électrique principal 130 et de la formation d'un arc série.

Si la tension électrique *Uac* devait varier à cause de variations de température le long du câblage électrique principal, la tension *Ubd* varierait de la même manière étant donné que le câblage électrique témoin 140 est installé le long du câblage électrique principal 130 et que le courant *I2* est ajusté sur le courant *I1*. La variation de potentiel électrique le long du câble de retour 145 serait, quant à elle, négligeable. Un défaut du câblage électrique principal 130 entraînant la formation d'un arc série ou d'une élévation de résistance de connexion serait détecté malgré ces variations de température.

L'exposé ci-dessus détaille des modes de réalisation reposant sur un générateur électrique fournissant une tension continue positive. Les adapter à un générateur fournissant une tension continue négative est alors trivial pour l'homme du métier (sens du courant, branchement des entrées des amplificateurs différentiels DIFF et du comparateur COMP 350, etc.).

Dans le cas d'un générateur de tension alternative, les tensions « e » en sortie de l'amplificateur différentiel DIFF 342 et « f » en sortie de l'amplificateur différentiel DIFF 341 sont en amont transformées en valeur efficace (dite valeur RMS, « Root Mean Square » en anglais), en utilisant par exemple un convertisseur ou un redresseur double alternance sans seuil suivi d'un filtre passe-bas, avant d'entrer sur l'amplificateur différentiel DIFF 343.

## Revendications

1. Système de détection pour détecter dans une installation électrique à tension continue un défaut dans un câblage électrique (130), dit câblage électrique principal, de section *S1*, le câblage électrique principal (130) étant installé de sorte qu'il subit des variations de température ambiante sur sa longueur, le système de détection comportant :
- un autre câblage électrique (140), dit câblage électrique témoin, de section S2 inférieure à la section *S1*, destiné à être placé en aller et retour le long du câblage électrique principal (130) ;
- un dispositif de surveillance (150) ;
- un câble de retour (145) ramenant le potentiel électrique en sortie du câblage électrique principal (130) vers le dispositif de surveillance (150) ; le dispositif de surveillance comportant :
- un générateur de courant contrôlable (320) agencé pour injecter en entrée du câble électrique témoin (140), un courant *I2* égal à un courant *I1* atténué par un facteur d'atténuation *G1*, le courant *I1* parcourant le câblage électrique principal (130), le générateur de courant contrôlable (320) étant connecté entre l'entrée et la sortie du câblage électrique témoin (140), le facteur d'atténuation *G1* étant tel que les courants *I1* et *I2* entraînent respectivement la même élévation de température dans le câblage électrique principal (130) et dans le câblage électrique témoin (140) ; et
- une circuiterie électronique (150) comportant un premier amplificateur différentiel (341) réalisé grâce à un amplificateur opérationnel connecté sur une première entrée à l'entrée du câblage électrique principal (130) et sur une seconde entrée à la sortie du câblage électrique principal (130), via le câble de retour (145), la circuiterie électronique étant agencée pour déterminer une différence de tensions entre la sortie du premier amplificateur différentiel (341) et une adaptation grâce à un gain *G2* de la tension entre l'entrée et la sortie du câblage électrique témoin (140), avec G2 = *S2* / (2.*G1.S1*)*,* et pour détecter un défaut dans le câblage électrique principal (130) lorsque ladite différence de tensions dépasse une marge prédéfinie.

2. Système de détection selon la revendication 1, comportant une sonde de courant (310) agencée pour mesurer l'intensité du courant *I1*, et dans lequel la circuiterie électronique (150) comporte :
- un atténuateur (330) agencé pour piloter le générateur de courant contrôlable (320) en fonction de l'intensité du courant *I1* mesurée par la sonde de courant (310) ;
- un amplificateur différentiel (342) agencé pour indiquer en sortie une valeur, adaptée grâce au gain *G2,* de tension entre l'entrée et la sortie du câblage électrique témoin (140) ;
- un troisième amplificateur différentiel (343) agencé pour indiquer en sortie quelle différence existe entre la tension en sortie du second amplificateur différentiel (342) et la tension en sortie du premier amplificateur différentiel (341) ; et
- un comparateur (350) agencé pour comparer la sortie du troisième amplificateur différentiel (343) avec un potentiel prédéfini *Vref* correspondant à ladite marge prédéfinie.

3. Système de détection selon la revendication 1 ou 2, dans lequel un filtre passe-bas (360) est présent en sortie du comparateur (350).

4. Installation électrique (110) comportant un câblage électrique (130), dit câblage électrique principal, le câblage électrique principal (130) étant destiné à être installé dans un environnement où le câblage électrique principal (130) subit des variations de température ambiante sur sa longueur, et comportant en outre un système de détection selon l'une quelconque des revendications 1 à 3.

5. Installation électrique selon la revendication 4, dans laquelle le câblage électrique témoin (140) est placé, sur sa longueur d'aller et retour, contre le câblage électrique principal (130).

6. Installation électrique selon la revendication 4 ou 5, comportant en outre un disjoncteur et dans laquelle la circuiterie électronique est agencée pour déclencher le disjoncteur lorsque la différence de tensions entre la sortie du premier amplificateur différentiel (341) et l'adaptation grâce à un gain *G2* de la tension entre l'entrée et la sortie du câblage électrique témoin (140) dépasse ladite marge prédéfinie.

7. Aéronef (100) comportant une installation électrique (110) selon l'une quelconque des revendications 4 à 6, le câblage électrique principal (130) étant installé dans des zones de l'aéronef (100) soumises à des températures ambiantes différentes.

8. Aéronef (100) selon la revendication 7, dans lequel le câblage électrique principal (130) est installé entre un générateur électrique (120) installé au niveau d'une aile de l'aéronef (100) en sortie d'un turboréacteur et un centre de distribution électrique (160) installé dans la cabine pressurisée de l'aéronef (100).

## Patentansprüche

1. Erkennungssystem zur Erkennung, in einer elektrischen Gleichspannungsanlage, eines Fehlers in einer elektrischen Verkabelung (130), als elektrische Hauptverkabelung bezeichnet, mit einem Querschnitt 51, wobei die elektrische Hauptverkabelung (130) so installiert ist, dass sie über ihre Länge Umgebungstemperaturschwankungen erfährt, wobei das Erkennungssystem Folgendes umfasst:
- eine weitere elektrische Verkabelung (140), als elektrische Kontrollverkabelung bezeichnet, mit einem Querschnitt S2, der kleiner als der Querschnitt S1 ist, die dazu bestimmt ist, entlang der Hin- und Rückleitung der elektrischen Hauptverkabelung (130) platziert zu sein;
- eine Überwachungsvorrichtung (150);
- ein Rückleitungskabel (145), das das elektrische Potenzial am Ausgang der elektrischen Hauptverkabelung (130) zu der Überwachungsvorrichtung (150) führt;
wobei die Überwachungsvorrichtung Folgendes umfasst:
- einen steuerbaren Stromerzeuger (320), der dazu angeordnet ist, am Eingang der elektrischen Kontrollverkabelung (140) einen Strom *I2* einzuspeisen, der gleich einem Strom *I1*, gedämpft um einen Dämpfungsfaktor *G1*, ist, wobei der Strom *I1* durch die elektrische Hauptverkabelung (130) fließt, wobei der steuerbare Stromerzeuger (320) zwischen dem Eingang und dem Ausgang der elektrischen Kontrollverkabelung (140) verbunden ist, wobei der Dämpfungsfaktor *G1* derart ist, dass die Ströme *I1* und *I2* jeweils den gleichen Temperaturanstieg in der elektrischen Hauptverkabelung (130) bzw. in der elektrischen Kontrollverkabelung (140) bewirken; und
- einen elektronischen Schaltkreis (150), der einen ersten Differenzverstärker (341) umfasst, der mit Hilfe eines Operationsverstärkers ausgeführt ist, der an einem ersten Eingang mit dem Eingang der elektrischen Hauptverkabelung (130) und, über das Rückleitungskabel (145), an einem zweiten Eingang mit dem Ausgang der elektrischen Hauptverkabelung (130) verbunden ist, wobei der elektronische Schaltkreis dazu angeordnet ist, eine Spannungsdifferenz zwischen dem Ausgang des ersten Differenzverstärkers (341) und einer Anpassung, dank einer Verstärkung G2, der Spannung zwischen dem Eingang und dem Ausgang der elektrischen Kontrollverkabelung (140), mit *G2* = *S2*/*(2.G1.S1)*, zu bestimmen und einen Fehler in der elektrischen Hauptverkabelung (130) zu erkennen, wenn die Spannungsdifferenz eine vordefinierte Marge überschreitet.

2. Erkennungssystem nach Anspruch 1, das eine Stromsonde (310) umfasst, die dazu angeordnet ist, die Stromstärke *I1* zu messen, und wobei der elektronische Schaltkreis (150) Folgendes umfasst:
- ein Dämpfungsglied (330), das dazu angeordnet ist, den steuerbaren Stromerzeuger (320) in Abhängigkeit von der Stärke des Stroms *I1*, die von der Stromsonde (310) gemessen wird, anzusteuern;
- einen Differenzverstärker (342), der dazu angeordnet ist, am Ausgang einen Wert, der dank der Verstärkung G2 angepasst wird, einer Spannung zwischen dem Eingang und dem Ausgang der elektrischen Kontrollverkabelung (140) anzugeben;
- einen dritten Differenzverstärker (343), der dazu angeordnet ist, am Ausgang anzugeben, welche Differenz zwischen der Spannung am Ausgang des zweiten Differenzverstärkers (342) und der Spannung am Ausgang des ersten Differenzverstärkers (341) besteht; und
- einen Komparator (350), der dazu angeordnet ist, den Ausgang des dritten Differenzverstärkers (343) mit einem vordefinierten Potenzial *Vref,* das der vordefinierten Marge entspricht, zu vergleichen.

3. Erkennungssystem nach Anspruch 1 oder 2, wobei sich am Ausgang des Komparators (350) ein Tiefpassfilter (360) befindet.

4. Elektrische Anlage (110), die eine elektrische Verkabelung (130), als elektrische Hauptverkabelung bezeichnet, umfasst, wobei die elektrische Hauptverkabelung (130) dazu bestimmt ist, in einer Umgebung installiert zu sein, in der die elektrische Hauptverkabelung (130) über ihre Länge Umgebungstemperaturschwankungen erfährt, und die ferner ein Erkennungssystem nach einem beliebigen der Ansprüche 1 bis 3 umfasst.

5. Elektrische Anlage nach Anspruch 4, wobei die elektrische Kontrollverkabelung (140) über ihre Hin- und Rückleitungslänge direkt an der elektrischen Hauptverkabelung (130) platziert ist.

6. Elektrische Anlage nach Anspruch 4 oder 5, die ferner einen Schutzschalter umfasst, und wobei der elektronische Schaltkreis dazu angeordnet ist, den Schutzschalter auszulösen, wenn die Spannungsdifferenz zwischen dem Ausgang des ersten Differenzverstärkers (341) und der Anpassung, dank einer Verstärkung G2, der Spannung zwischen dem Eingang und dem Ausgang der elektrischen Kontrollverkabelung (140) die vordefinierte Marge überschreitet.

7. Luftfahrzeug (100), das eine elektrische Anlage (110) nach einem beliebigen der Ansprüche 4 bis 6 umfasst, wobei die elektrische Hauptverkabelung (130) in Bereichen des Luftfahrzeugs (100) installiert ist, die unterschiedlichen Umgebungstemperaturen unterliegen.

8. Luftfahrzeug (100) nach Anspruch 7, wobei die elektrische Hauptverkabelung (130) zwischen einem elektrischen Generator (120), der im Bereich eines Flügels des Luftfahrzeugs (100) am Ausgang eines Turbinentriebwerks installiert ist, und einer Stromverteilungseinheit (160), die in der Druckkabine des Luftfahrzeugs (100) installiert ist, installiert ist.

## Claims

1. Detection system for detecting, in a DC electrical apparatus, a fault in a wiring harness (130), referred to as the main wiring harness, of cross section *S1*, the main wiring harness (130) being installed so that it undergoes variations in ambient temperature over its length, the detection system comprising:
- another wiring harness (140), referred to as the control wiring harness, of cross section S2 which is less than the cross section *S1*, intended to be placed both ways along the main wiring harness (130);
- a monitoring device (150);
- a return cable (145) bringing the electrical potential at the output of the main wiring harness (130) back to the monitoring device (150);
the monitoring device comprising:
- a controllable current generator (320) arranged to inject, at the input of the control electrical cable (140), a current *I2* which is equal to a current *I1* attenuated by an attenuation factor *G1*, the current *I1* flowing through the main wiring harness (130), the controllable current generator (320) being connected between the input and the output of the control wiring harness (140), the attenuation factor *G1* being such that the currents *I1* and *I2* cause the same temperature rise in the main wiring harness (130) and in the control wiring harness (140), respectively; and
- electronic circuitry (150) comprising a first differential amplifier (341) produced by virtue of an operational amplifier connected by a first input to the input of the main wiring harness (130) and by a second input to the output of the main wiring harness (130), via the return cable (145), the electronic circuitry being arranged to determine a voltage difference between the output of the first differential amplifier (341) and a matching by virtue of a gain G2 in the voltage between the input and the output of the control wiring harness (140), with *G2* = *S2* / (2*.G1.S1*)*,* and to detect a fault in the main wiring harness (130) when said voltage difference exceeds a predefined margin.

2. Detection system according to Claim 1, comprising a current probe (310) arranged to measure the magnitude of the current *I1*, and in which the electronic circuitry (150) comprises:
- an attenuator (330) arranged to drive the controllable current generator (320) in accordance with the magnitude of the current *I1* measured by the current probe (310);
- a differential amplifier (342) arranged to indicate, at output, a voltage value, matched by virtue of the gain G2, between the input and the output of the control wiring harness (140);
- a third differential amplifier (343) arranged to indicate, at output, what difference there is between the voltage at the output of the second differential amplifier (342) and the voltage at the output of the first differential amplifier (341); and
- a comparator (350) arranged to compare the output of the third differential amplifier (343) with a predefined potential *Vref* corresponding to said predefined margin.

3. Detection system according to Claim 1 or 2, in which a low-pass filter (360) is present at the output of the comparator (350).

4. Electrical apparatus (110) comprising a wiring harness (130), referred to as the main wiring harness, the main wiring harness (130) being intended to be installed in an environment where the main wiring harness (130) undergoes variations in ambient temperature over its length, and further comprising a detection system according to any one of Claims 1 to 3.

5. Electrical apparatus according to Claim 4, in which the control wiring harness (140) is placed, over its length both ways, against the main wiring harness (130).

6. Electrical apparatus according to Claim 4 or 5, further comprising a circuit breaker and in which the electronic circuitry is arranged to trip the circuit breaker when the voltage difference between the output of the first differential amplifier (341) and the matching by virtue of a gain G2 in the voltage between the input and the output of the control wiring harness (140) exceeds said predefined margin.

7. Aircraft (100) comprising an electrical apparatus (110) according to any one of Claims 4 to 6, the main wiring harness (130) being installed in areas of the aircraft (100) which are subjected to different ambient temperatures.

8. Aircraft (100) according to Claim 7, in which the main wiring harness (130) is installed between an electric generator (120) installed at a wing of the aircraft (100) at the outlet of a turbojet and an electrical power centre (160) installed in the pressurized cabin of the aircraft (100).
